# EUROPEAN PATENT SPECIFICATION

(11) **EP 1 286 577 B1**
(45) Date of publication and mention of the grant of the patent: **27.04.2005**
(21) Application number: 02715766.8
(22) Date of filing: 16.01.2002
(51) Int. Cl.: H05K 3/34

(54) **METHOD OF FIXING ELECTRONIC PART**
VERFAHREN ZUM FIXIEREN EINES ELEKTRONISCHEN TEILS
PROCEDE DE FIXATION D'UNE PIECE ELECTRONIQUE

(30) Priority: 18.01.2001 JP 2001009784
(43) Date of publication of application: 26.02.2003
(73) Proprietor: MATSUSHITA ELECTRIC INDUSTRIAL CO., LTD., Kadoma-shi, Osaka 571-8501 (JP)
(72) Inventor: ASANO, Mitsutoshi, Matsusaka-shi, Mie 515-0045 (JP); YAMAMURA, Masami, Kadoma-shi, Osaka 571-0016 (JP)
(74) Representative: Holmes, Miles
(86) International application number: PCT/JP2002/000255
(87) International publication number: WO 2002/058445

(56) References cited:
- JP-A- 4 167 496
- JP-A- 6 077 640
- JP-A- 7 038 251
- JP-A- 8 078 828
- US-A- 5 590 462
- PATENT ABSTRACTS OF JAPAN vol. 1995, no. 05, 30 June 1995 (1995-06-30) & JP 07 038251 A (SONY CORP), 7 February 1995 (1995-02-07)
- PATENT ABSTRACTS OF JAPAN vol. 018, no. 022 (E-1490), 13 January 1994 (1994-01-13) & JP 05 259633 A (HITACHI LTD), 8 October 1993 (1993-10-08)
- CARDINAL R E: "Surface mount on the solder side-a modified process compatible with standard wave soldering" FIFTH IEEE/CHMT INTERNATIONAL ELECTRONIC MANUFACTURING TECHNOLOGY SYMPOSIUM - DESIGN TO MANUFACTURING TRANSFER CYCLE. PROCEEDINGS 1988 (IEEE CAT. NO. 88CH2648-4), 1988, pages 28-31, XP010078219 IEEE, New York, USA

## Description

### TECHNICAL FIELD

The present invention relates to a method of fixing electronic components for bonding and fixing a plurality of electronic components on a circuit board.

### BACKGROUND ART

Conventionally, a plurality of electronic components has been fixed on a circuit board (hereinafter recited as a "board") by the following method using a conductive bonding agent such as solder.

First, a non-conductive adhesive is applied between the lands for bonding a first electronic component on the board.

Next, a first paste-form conductive bonding agent is applied onto first lands for bonding a first electronic component, and electrodes of the first electronic component is bonded to the first conductive bonding agent.

Subsequently, the first conductive bonding agent is melted by heating or the like and hardened in order to bond and fix the electrodes of the first electronic component on the first lands. At the same time, the first electronic component has been fixed on the board by using non-conductive adhesive. A fixing by the non-conductive adhesive is sometimes performed prior to a bonding by the first conductive bonding agent.

Next, electrodes of a second electronic component are bonded and fixed on second lands of the board by using a second conductive bonding agent whose melting temperature is equal to or higher than the melting temperature of the first conductive bonding agent.

That is, when the electrodes of the second electronic component are fixed on the second lands of the board, to prevent the first electronic component from accidentally moving due to a melting of the first conductive bonding agent of the first electronic component, the first electronic component has been previously fixed beforehand.

Here, there arises a problem such that due to the recent trend of reduction in size of electronic components, the space between the first lands is very narrow and, when a non-conductive adhesive is applied there, a part of the adhesive sometimes happen to stick on the fist lands. In case a non-conductive adhesive sticks on the first land, it may sometimes cause a problem in that the first electronic component cannot be reliably fixed on the first lands by the first conductive bonding agent. To avoid the problem, it takes much time and labor for the application of non-conductive adhesive.

In order to avoid the problem, the melting temperature of the first conductive bonding agent is sometimes set higher than the melting temperature of the second conductive bonding agent in the production of the electronic equipment. In this case, though, the first conductive bonding agent is not melted, the bonding agent is subjected to a repeated heating and becomes fragile because of a crystal growth of inter-metallic compound, for example. As a result, the reliability of connection by the first conductive bonding agent is considerably decreased.

Japanese Patent Laid Open Application H07-38251A discloses a method to fix an electronic component on a double sided board wherein at least two corners of a package are fixed with a heat curable adhesive on one surface of the circuit board after a first re-flow soldering. The adhesive is cured during a pre-heating process prior to a second re-flow soldering of another component onto another surface of the circuit board. In the disclosure, the adhesive is applied to have a specific thickness to support the component even if the surface of the component is contaminated with a release agent which is used at a time of encapsulating resin moulding. Thus, a sufficient amount of the adhesive is required. Moreover, conventional adhesive such as an epoxy resin becomes extremely low viscosity state when heated at high temperature and flows to have a thin thickness. Thus it cannot fully support the component at a time of the second soldering.

The present invention is intended to facilitate the application of non-conductive adhesive in the bonding of electronic components onto a board as mentioned above.

### DISCLOSURE OF THE INVENTION

The present invention is defined in the claims.

According to the present invention, after the first electronic component is bonded onto the first lands by the conductive bonding agent, the first electronic component is fixed on the board by using the non-conductive adhesive. Accordingly, when the second electronic component is bonded onto the second land of the board, accidental moving of the first electronic component previously fixed can be prevented. That is, when the second electronic component is bonded by the second conductive bonding agent, the first electronic component will not accidentally move from the first lands when the first conductive bonding agent is melted.

Particularly, when the first electronic component is smaller than the second electronic component, and it is fixed on the board by using non-conductive adhesive, care should be taken so that the non-conductive adhesive does not exist between the electrodes of the first electronic component and the first lands of the board. Since the first electronic component is smaller than the second electronic component, much time and labor will be required for the application of non-conductive adhesive. However, in the present invention, the first electronic component is bonded onto the first lands before fixing the first electronic component on the board by using non-conductive adhesive.

As a result, no accurate control is needed for the application of non-conductive adhesive, and thereby, it is very easy to perform the first electronic component fixing operation.

### BRIEF DESCRIPTION OF THE DRAWINGS

Fig. 1 is a perspective view showing one preferred embodiment of a fixing method of the present invention.
Figs. 2 (a) - (e) and Figs. 3 (a) - (c) are front views showing a fixing method of the present invention.
Fig. 4 is an enlarged front view showing a fixing method of the present invention.

### DETAILED DESCRIPTION OF PREFERRED EMBODIMENTS

One preferred embodiment of the present invention will be described in the following with reference to the appended drawings.

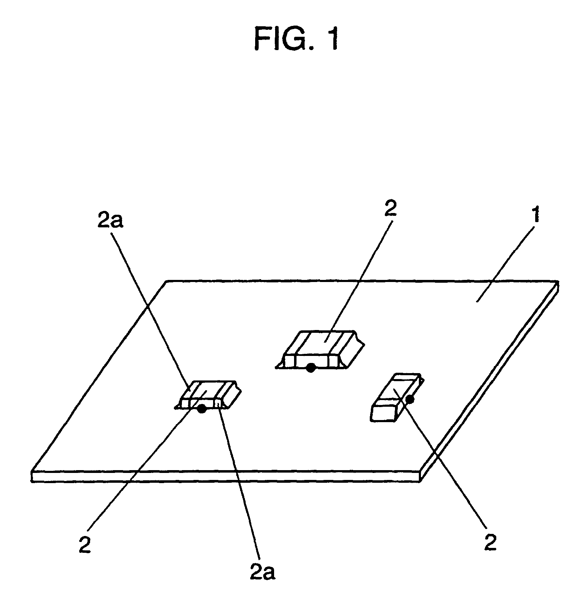

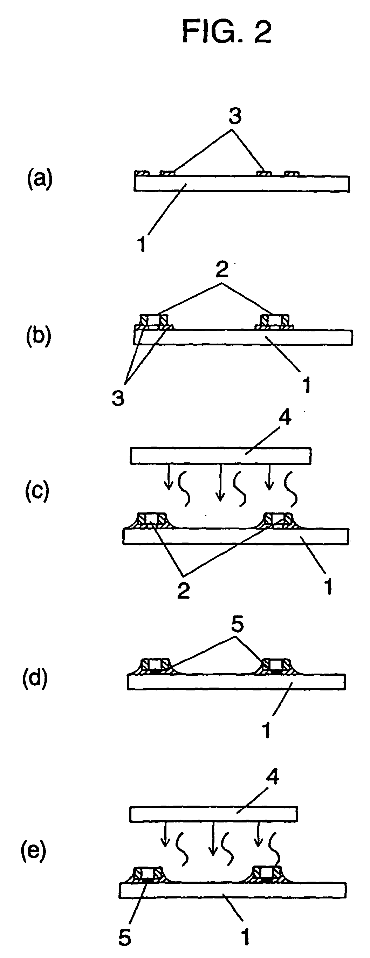

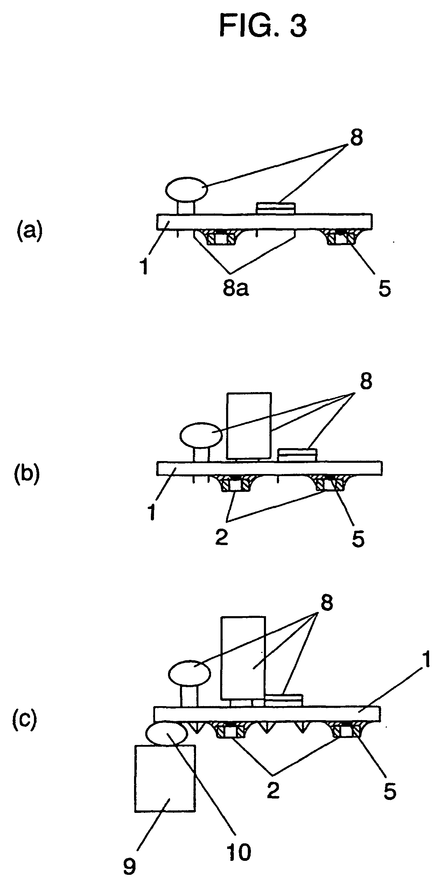

In Fig. 1, on a surface and a back of board 1 made of ceramic, resin or the like are disposed lands for mounting various electronic components (not shown) and wiring patterns electrically connecting the electronic components. Described here is a step of mounting, for example, a first electronic component 2, a chip component, on the surface of the board. as shown in Fig. 1. It should be noted that in Figs. 2(a) - (e) and Figs. 3(a) - (c), spaces between the components and the board are shown in exaggeration.

First, as shown in Fig. 2 (a) paste-form first conductive bonding agent 3 that is called, for example, cream solder is applied on first lands (not shown) of the board 1.

Next, as shown in Fig. 2 (b), electrodes 2a at both ends of the first electronic component 2 are bonded on the conductive bonding agent 3.

After that, as shown in Fig. 2 (c), the conductive bonding agent 3 is melted by heating means 4 and hardened to bond the electrodes 2a of the electronic component 2 onto the first lands.

Subsequently, as shown in Fig. 2 (d), the electronic component 2 is fixed on the board 1 by using non-conductive adhesive 5 made of resin or the like. The bonding with non-conductive adhesive 5 is performed by using a means such as a thermal curing of a thermosetting resin such as epoxy resin, an application of ultraviolet ray to an ultraviolet curing resin, and an anaerobic curing of an anaerobic curing resin.

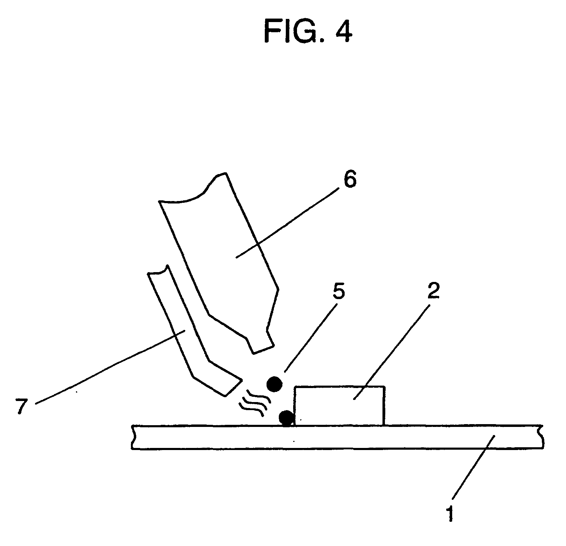

A specific example of bonding by heating non-conductive adhesive 5 is shown in Fig. 4. Firstly, non-conductive adhesive 5 is dispensed from a dispenser 6 toward the outer periphery of the electronic component 2.

After that, at least a part of non-conductive adhesive 5 sticking to the board 1 is moved to the electronic component 2 side by pressurized air from a nozzle 7, and as shown in Fig. 2 (e), the conductive adhesive 5 is heated and cured by heating means 4.

In this way, since the conductive adhesive 5 sticking to the board 1 is moved by pressurized air to the electronic component 2, the electronic component 2 is precisely fixed on the board 1 by non-conductive adhesive 5.

Also, since the non-conductive adhesive 5 is moved to the electronic component 2 by means of pressurized air, unlike the case of using other means to move the non-conductive adhesive 5 dispensed onto the board 1, there is no such problem that a part of the adhesive is taken away by a sticking to the means. That is, all the non-conductive adhesive 5 is used for the adhesion and bonding of the electronic component 2, thereby assuring an adhesive strength of the electronic component 2 to the board 1.

Also, when heated pressurized air is used, the non-conductive adhesive 5 such as epoxy resin is decreased in viscosity and becomes easier to move, and the reliability of adhesion of the electronic component 2 may be enhanced.

After the first electronic component 2 is fixed on the board 1 by using non-conductive adhesive 5, the board 1 is reversed as shown in Fig. 3 (a), and lead wires 8a of second electronic component 8 is put into through-holes (not shown) of the board 1 from the back side as shown in Fig. 3 (a), (b).

Next, as shown in Fig. 3 (c), second conductive bonding agent 10, molten solder or the like, flows out from solder tank 9 disposed thereunder, by which the lead wires 8a are bonded to second lands (not shown) of board 1.

A melting temperature of the second conductive bonding agent 10 is higher than a melting temperature of the first conductive bonding agent 3. Under these conditions, it is possible to solve the conventional problem that the reliability of connection is decreased due to a deterioration of the conductive bonding agent of high melting point. When the lead wires 8a of the second electronic component 8 are fixed on the second lands of board 1, the first conductive bonding agent 3 is melted first, causing the first electronic component 2 fixed with it to accidentally move. Therefore, in order to prevent such problem, the first electronic component 2 is fixed on the board 1 by using non-conductive adhesive 5.

As described above, according to the present invention, in bonding of electronic components onto a board through a plurality of bonding processes such as a solder reflow process, there is no problem of generation of defective connection due to the movement of previously bonded electronic components from the lands since the electronic components are fixed by using non-conductive adhesive 5.

Also, the melting temperature of the second conductive bonding agent 10 is higher than the melting temperature of the second conductive bonding agent 3. As a result, it is possible to solve such conventional problem that the reliability of connection is decreased due to the deterioration of the conductive bonding agent of high melting point.

Further, the application of non-conductive adhesive is performed after the bonding of the first conductive bonding agent 3. Accordingly, no accurate control of a position of the application is needed for the application of non-conductive adhesive, thereby making the fixing operation very easy.

In the above description, in order to simplify the description, it refers to the bonding of the first and the second electronic components. However, the present invention is not applied only to individual electronic components, but it is applicable to a group of first electronic components and second electronic components, and also to electronic equipment using many groups of electronic components such as a group of third or more electronic components.

### INDUSTRIAL APPLICABILITY

As described above, according to the method of fixing electronic components of the present invention, it is possible to obtain a great deal of advantage in the production of electronic equipment in which a plurality of electronic components are fixed on circuit boards through a plurality of times of application, melting and hardening of the conductive bonding agent. Particularly, the advantage may be further enhanced in the production of electronic equipment using ultra-small-sized electronic components in combination with larger electronic components.

### Reference numerals

- 1: Circuit board
- 2: First electronic component
- 3: First conductive bonding agent
- 5: Non-conductive adhesive
- 6: Dispenser
- 8: Second electronic component
- 10: Second conductive bonding agent

## Claims

1. A method of fixing electronic components comprising the following steps carried out in the specified order (a), (b) and (c):
(a) bonding a first electronic component (2) onto first lands of a circuit board (1) by using a first conductive bonding agent (3);
(b) fixing said first electronic component (2) on said circuit board (1) by using a non-conductive adhesive (5); and
(c) bonding a second electronic component (8) on second lands of said circuit board (1) by using a second conductive bonding agent (10);
**characterised in that**
a melting temperature of said second conductive bonding agent (10) is higher than a melting temperature of said first conductive bonding agent (3).

2. The method of fixing an electronic component of claim 1, wherein said first and said second conductive bonding agents (3, 10) are solder.

3. The method of fixing an electronic component of claim 1, wherein said second electronic component (8) is larger in shape than said first electronic component (2).

4. The method of fixing an electronic component of claim 1, wherein said non-conductive adhesive (5) is one selected from the group consisting of thermosetting resin, ultraviolet curing resin, and anaerobic curing resin.

5. The method of fixing an electronic component of claim 1, wherein at least a part of said non-conductive adhesive (5) is moved to the first electronic component side by pressurized air.

6. The method of fixing an electronic component of claim 5, wherein said pressurized air is heated.

7. The method of fixing an electronic component of claim 1, wherein said non-conductive adhesive (5) is supplied by a dispenser (6).

## Patentansprüche

1. Verfahren zum Befestigen von elektronischen Bauelementen mit den folgenden Schritten, die in der festgelegten Reihenfolge a), b) und c) ausgeführt werden:
a) Bonden eines ersten elektronischen Bauelements (2) auf erste Kontaktflecke einer Leiterplatte (1) mittels eines ersten leitfähigen Haftvermittlers (3);
b) Befestigen des ersten elektronischen Bauelements (2) auf der Leiterplatte (1) mittels eines nichtleitfähigen Klebstoffs (5) und
c) Bonden eines zweiten elektronischen Bauelements (8) auf zweite Kontaktflecke der Leiterplatte (1) mittels eines zweiten leitfähigen Haftvermittlers (10),
**dadurch gekennzeichnet, dass** die Schmelztemperatur des zweiten leitfähigen Haftvermittlers (10) höher als die Schmelztemperatur des ersten leitfähigen Haftvermittlers (3) ist.

2. Verfahren zum Befestigen von elektronischen Bauelementen nach Anspruch 1, **dadurch gekennzeichnet, dass** der erste und der zweite leitfähige Haftvermittler (3, 10) ein Lötmetall sind.

3. Verfahren zum Befestigen von elektronischen Bauelementen nach Anspruch 1, **dadurch gekennzeichnet, dass** das zweite elektronische Bauelement (8) eine größere Form als das erste elektronische Bauelement (2) hat.

4. Verfahren zum Befestigen von elektronischen Bauelementen nach Anspruch 1, **dadurch gekennzeichnet, dass** der nichtleitfähige Klebstoff (5) aus der Gruppe hitzehärtbarer Kunststoff, Ultraviolett-härtbarer Kunststoff und anaerob härtbarer Kunststoff gewählt ist.

5. Verfahren zum Befestigen von elektronischen Bauelementen nach Anspruch 1, **dadurch gekennzeichnet, dass** zumindest ein Teil des nichtleitfähigen Klebstoffs (5) mit Druckluft zu dem ersten elektronischen Bauelement bewegt wird.

6. Verfahren zum Befestigen von elektronischen Bauelementen nach Anspruch 5, **dadurch gekennzeichnet, dass** die Druckluft erwärmt wird.

7. Verfahren zum Befestigen von elektronischen Bauelementen nach Anspruch 1, **dadurch gekennzeichnet, dass** der nichtleitfähige Klebstoff (5) mit einem Verteiler (6) zugeführt wird.

## Revendications

1. Procédé de fixation de composants électroniques comprenant les étapes suivantes exécutées dans l'ordre spécifié (a), (b), et (c) :
(a) souder un premier composant électronique (2) sur des premières plages de connexion d'une carte de circuit (1) en utilisant un premier agent de soudage conducteur (3),
(b) fixer ledit premier composant électronique (2) sur ladite carte de circuit (1) en utilisant un adhésif non-conducteur (5), et
(c) souder un second composant électronique (8) sur des secondes plages de connexion de ladite carte de circuit (1) en utilisant un second agent de soudage conducteur (10),
**caractérisé en ce que**
une température de fusion dudit second agent de soudage conducteur (10) est supérieure à une température de fusion dudit premier agent de soudage conducteur (3).

2. Procédé de fixation d'un composant électronique selon la revendication 1, dans lequel ledit premier et ledit second agents de soudage conducteurs (3, 10) sont une soudure à l'étain.

3. Procédé de fixation d'un composant électronique selon la revendication 1, dans lequel ledit second composant électronique (8) a une forme plus grande que ledit premier composant électronique (2).

4. Procédé de fixation d'un composant électronique selon la revendication 1, dans lequel ledit adhésif non-conducteur (5) est un élément sélectionné parmi le groupe constitué de résine thermodurcissable, de résine à cuisson par ultraviolets et de résine à cuisson anaérobie.

5. Procédé de fixation d'un composant électronique selon la revendication 1, dans lequel au moins une partie dudit adhésif non-conducteur (5) est déplacée du côté du premier composant électronique par de l'air sous pression.

6. Procédé de fixation d'un composant électronique selon la revendication 5, dans lequel ledit air sous pression est chauffé.

7. Procédé de fixation d'un composant électronique selon la revendication 1, dans lequel ledit adhésif non-conducteur (5) est fourni par un distributeur (6).
